# EUROPÄISCHE PATENTANMELDUNG

(11) **EP 4 481 951 A1**
(43) Veröffentlichungstag der Anmeldung: **25.12.2024**
(21) Anmeldenummer: 24176014.9
(22) Anmeldetag: 15.05.2024
(51) Int. Cl.: H01R 13/46, G06K 19/06, H01R 13/629, H01R 13/641, H01R 43/26

(54) **SICHERUNGSVORRICHTUNG MIT ERKENNUNGSMERKMAL UND VERDECKUNGSMERKMAL RÜCKEN AN RÜCKEN ANGEORDNET**

(30) Priorität: 06.06.2023 DE 102023114789
(71) Anmelder: Lisa Dräxlmaier GmbH, 84137 Vilsbiburg (DE)
(72) Erfinder: Wimmer, Stefan, 84098 Hohenthann (DE); Wilhelm, Sebastian, 66625 Nohfelden (DE); Neumayer, Franziska, 84144 Geisenhausen (DE)

(57) **Zusammenfassung**

Die Offenbarung betrifft eine Sicherungsvorrichtung (100) zur Sicherung einer Verriegelung eines Verriegelungselements (110), wobei die Sicherungsvorrichtung (100) Folgendes umfasst: ein Verriegelungselement (110), das von einer ersten Verriegelungsstellung (111) in eine zweite Verriegelungsstellung (112) bewegbar ist, wobei das Verriegelungselement (110) in der zweiten Verriegelungsstellung (112) eine Verriegelung bewirkt; und ein Klappelement (120) mit einem Erkennungsmerkmal (124) und einem Verdeckungsmerkmal (123), die in absoluter Lage zueinander auf dem Klappelement (120) angeordnet sind, wobei das Klappelement (120) von einer ersten Klappstellung (121), in der das Verdeckungsmerkmal (123) das Erkennungsmerkmal (124) verdeckt, in eine zweite Klappstellung (122), in der das Erkennungsmerkmal (124) sichtbar ist, bewegbar ist, wenn sich das Verriegelungselement (110) in der zweiten Verriegelungsstellung (112) befindet, wobei das Erkennungsmerkmal (124) eine Information anzeigt.

## Beschreibung

### Technisches Gebiet

Die vorliegende Erfindung betrifft eine Sicherungsvorrichtung mit Erkennungsmerkmal und Verdeckungsmerkmal, die in absoluter Lage zueinander angeordnet sind. Die Sicherungsvorrichtung dient zur Sicherung einer Verriegelung eines Verriegelungselements bzw. zur "Steckerpositions-Kontrolle" oder "Connector Position Assurance (CPA)" und ist zur Sicherung einer Verriegelung eines Steckergehäuses an einem Gegen-Steckergehäuse einsetzbar. Insbesondere betrifft die Erfindung eine CPA mit scanbarem Element, das sich selbst verdeckt.

### Stand der Technik

CPAs ("Connector Position Assurance") sollen verhindern, dass sich ein an einem Gegen-Steckergehäuse verrastetes Steckergehäuse unbeabsichtigt von dem Gegen-Steckergehäuse löst, was beispielsweise aufgrund von Vibrationen, temperaturbedingter Ausdehnung oder Schrumpfung, das Ziehen an einem im Steckergehäuse untergebrachten Kabel oder andere mechanische Einwirkungen passieren kann. Die CPA ist dafür zuständig als letztes zu bedienendes Element den Stecker mit seinem Gegenstück zu verriegeln. Um hier ein sicheres Verriegeln zu gewährleisten, wird gefordert, dass der finale Zustand der Verriegelung durch ein scanbares Element erfasst wird und dieses Element nur lesbar sein darf, wenn die CPA final geschlossen ist.

### Beschreibung der Erfindung

Eine Aufgabe der Erfindung ist es daher, eine geeignete Vorrichtung zu schaffen, mit der zuverlässig erkannt werden kann, ob eine Verriegelung vorliegt oder nicht, insbesondere für Stecker, bei denen eine CPA-Verriegelung erforderlich ist.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Durch die Anforderung, dass der Stecker einen hohen Automatisierungsgrad in Herstellung und Konfektionierung benötigt ist die Verwendung eines scanbaren Elementes zwingend notwendig als Kontrollfunktion. Die hier vorgestellte Erfindung betrifft eine Sicherungsvorrichtung mit Erkennungsmerkmal und Verdeckungsmerkmal, wobei das Erkennungsmerkmal als scanbares Element genutzt werden kann, um somit eine zuverlässige Kontrolle der Steckermontage zu gewährleisten und ein Scannen des Stecksystems im zusammengebauten Zustand zu ermöglichen. Üblicherweise ist der Stecker schon hergestellt und wird montiert. Dieser Montageprozess kann hier kontrolliert werden. Die hier vorgestellte Lösung kann auf verschiedene Stecksysteme angewendet werden und lässt sich leicht von einem Stecksystem auf ein anderes Stecksystem adaptieren.

Die Erfindung löst das Problem technisch, indem sich ein Verdeckungsmerkmal und Erkennungsmerkmal auf demselben Bauteil befinden und sich immer in absoluter Lage zueinander befinden. Die Verdeckung entsteht dadurch, dass sich das Element selbst durch einen Klappmechanismus verdeckt. Dieser Klappmechanismus wird über die CPA gesteuert. Erst nachdem der Bügel betätigt wurde, wird die CPA freigegeben und kann verriegelt werden. Nach Verriegelung gibt die CPA den Klappmechanismus frei und das zusätzliche Element kann bedient werden. Somit wird das Erkennungsmerkmal "aufgedeckt" und kann erfasst werden.

Grundfunktion hierbei ist ein Verdeckungsmerkmal und Erkennungsmerkmal, die sich immer in absoluter Lage zueinander befinden. Beide Merkmale bzw. Elemente sind immer absolut zueinander angeordnet. Eine relative Bewegung findet lediglich zwischen dem Verdeckungsmerkmal und beispielsweise dem Steckergehäuse statt oder zwischen dem Erkennungsmerkmal und beispielsweise dem Steckergehäuse.

Mit der hier vorgestellten Lösung lässt sich ein scanbares Element zum Scannen des Erkennungsmerkmals einsetzen, das als Kontrollfunktion in der Herstellung und Konfektionierung von Steckern mit hohem Automatisierungsgrad dienen kann.

Gemäß einem ersten Aspekt wird die oben beschriebene Aufgabe gelöst durch eine Sicherungsvorrichtung zur Sicherung einer Verriegelung eines Verriegelungselements, wobei die Sicherungsvorrichtung Folgendes umfasst: ein Verriegelungselement, das von einer ersten Verriegelungsstellung in eine zweite Verriegelungsstellung bewegbar ist, wobei das Verriegelungselement in der zweiten Verriegelungsstellung eine Verriegelung bewirkt; und ein Klappelement mit einem Erkennungsmerkmal und einem Verdeckungsmerkmal, die in absoluter Lage zueinander auf dem Klappelement angeordnet sind, wobei das Klappelement von einer ersten Klappstellung, in der das Verdeckungsmerkmal das Erkennungsmerkmal verdeckt, in eine zweite Klappstellung, in der das Erkennungsmerkmal sichtbar ist, bewegbar ist, wenn sich das Verriegelungselement in der zweiten Verriegelungsstellung befindet, wobei das Erkennungsmerkmal eine Information anzeigt. Diese Information kann eine Information über eine Verriegelung durch das Verriegelungselement beinhalten, aber es kann sich auch um jede andere Art von Information handeln. Durch das Erkennen der Information kann bereits die Verriegelung erkannt werden. Wird die Information nicht erkannt, so kann keine Verriegelung erkannt werden.

Die absolute Lage von Erkennungsmerkmal und Verdeckungsmerkmal auf dem Klappelement bedeutet hier, dass ein Koordinatensystem, welches das Erkennungsmerkmal definiert und ein Koordinatensystem, welches das Verdeckungsmerkmal definiert, in absoluter Lage zueinander auf dem Klappelement liegen, vorzugsweise auf der Vorderseite und der Rückseite des Klappelements.

Eine solche Sicherungsvorrichtung bietet den technischen Vorteil, dass ein sicheres und zuverlässiges Erkennen einer Verriegelung möglich ist. Das Erkennungsmerkmal lässt sich erkennen und beispielsweise über ein scanbares Element erfassen, so dass eine zuverlässige automatische Erkennung der Stellung des Verriegelungselements möglich ist. Damit lässt sich insbesondere eine automatische Erfassung des Zustands von Steckern, bei denen eine CPA-Verriegelung erforderlich ist, durchführen. Die Sicherungsvorrichtung erfüllt somit die Anforderungen, die an eine CPA-Verriegelung gestellt werden.

Gemäß einer beispielhaften Ausführungsform der Sicherungsvorrichtung sind das Verdeckungsmerkmal und das Erkennungsmerkmal in fester Lage auf dem Klappelement angebracht, so dass sich eine relative Lage des Verdeckungsmerkmals in Bezug auf das Erkennungsmerkmal bei einer Bewegung des Klappelements nicht ändert. Dies entspricht der oben beschriebenen absoluten Lage von Erkennungsmerkmal und Verdeckungsmerkmal zueinander.

Dies bietet den technischen Vorteil, dass es zu keiner relativen Lageänderung des Verdeckungsmerkmals in Bezug auf das Erkennungsmerkmal kommen kann. Die absolute Lage des Erkennungsmerkmals und des Verdeckungsmerkmals kann nicht verändert werden. Durch Umklappen des Klappelements wird die relative Lage zu einem Steckergehäuse geändert, wie weiter unten beschrieben. Durch diese Lageänderung im Gesamtsystem kann verdeckt oder aufgedeckt werden. Somit ist eine zuverlässige Feststellung der Lage des Klappelements und damit des Verriegelungszustands des Verriegelungselements möglich.

Gemäß einer beispielhaften Ausführungsform der Sicherungsvorrichtung weist das Klappelement eine erste Hauptseite und eine der ersten Hauptseite abgewandte zweite Hauptseite auf, wobei das Verdeckungsmerkmal auf der ersten Hauptseite des Klappelements oder zumindest einem Teil der ersten Hauptseite angebracht ist; und wobei das Erkennungsmerkmal auf der zweiten Hauptseite des Klappelements oder zumindest einem Teil der zweiten Hauptseite angebracht ist.

Dies bietet den technischen Vorteil, dass das Verdeckungsmerkmal und das Erkennungsmerkmal auf entgegengesetzten Seiten des Klappelements angeordnet sind und ein Umklappen des Klappelements entweder das eine oder das andere Merkmal erfassbar macht, so dass eine eindeutige Erkennung des Zustands des Klappelements und damit des Zustands des Verriegelungselements möglich ist.

Gemäß einer beispielhaften Ausführungsform der Sicherungsvorrichtung weist das Verdeckungsmerkmal eine erste geometrische Struktur auf; und das Erkennungsmerkmal weist eine zweite geometrische Struktur auf, die sich von der ersten geometrischen Struktur unterscheidet.

Dies bietet den technischen Vorteil, dass aufgrund der verschiedenen geometrischen Strukturen eindeutig erkannt werden kann, in welcher Stellung sich das Klappelement befindet und damit in welcher Stellung sich das Verriegelungselement befindet.

Gemäß einer beispielhaften Ausführungsform der Sicherungsvorrichtung ist das Erkennungsmerkmal erkennbar, beispielsweise mit einem Lesegerät lesbar, wenn es nicht durch das Verdeckungsmerkmal verdeckt ist.

Dies bietet den technischen Vorteil, dass der Zustand des Verriegelungselements sich sicher und zuverlässig mit einem Lesegerät, beispielsweise einem Scanner, bestimmen lässt. Damit kann eine automatisierte Montage von Stecksystemen effizient kontrolliert werden.

Gemäß einer beispielhaften Ausführungsform der Sicherungsvorrichtung ist das Erkennungsmerkmal mit einem Auge sichtbar, wenn es nicht durch das Verdeckungsmerkmal verdeckt ist.

Dies bietet den technischen Vorteil, dass das Erkennungsmerkmal durch das Bedienpersonal erkannt werden kann, aber auch maschinell über ein Lesegerät erfassbar ist.

Gemäß einer beispielhaften Ausführungsform der Sicherungsvorrichtung umfasst die Sicherungsvorrichtung ein Drehlager zum Lagern des Klappelements, wobei das Drehlager ausgebildet ist, eine Drehung des Klappelements in die erste Klappstellung und in die zweite Klappstellung auszuführen.

Dies bietet den technischen Vorteil, dass über das Drehlager das Klappelement leicht von der ersten Klappstellung in die zweite Klappstellung bewegt werden kann.

Gemäß einer beispielhaften Ausführungsform der Sicherungsvorrichtung ist die Sicherungsvorrichtung ausgebildet, eine Steckerpositions-Sicherung (CPA) zur Sicherung einer Verriegelung eines Steckergehäuses an einem Gegen-Steckergehäuse vorzunehmen.

Dies bietet den technischen Vorteil, dass der Zustand der CPA sich sicher durch ein scanbares Element erfassen lässt, welches nur dann lesbar ist, wenn die CPA final geschlossen ist.

Gemäß einer beispielhaften Ausführungsform der Sicherungsvorrichtung umfasst die Sicherungsvorrichtung ferner: ein Spannelement zum Einspannen eines Steckergehäuses in ein Gegen-Steckergehäuse, wobei das Spannelement von einer offenen Spannelementstellung, in der das Steckergehäuse in das Gegen-Steckergehäuse einführbar ist, in eine geschlossene Spannelementstellung, in der das Steckergehäuse elektrisch kontaktierend mit dem Gegen-Steckergehäuse fixiert ist, bewegbar ist; wobei das Verriegelungselement an dem Spannelement angebracht ist und ausgebildet ist, das Spannelement zu verriegeln oder zu entriegeln. Wie oben beschrieben zeigt das Erkennungsmerkmal eine Information an, beispielsweise eine Information über eine Verriegelung oder Nicht-Verriegelung des Spannelements durch das Verriegelungselement. Auch jede andere Information kann angezeigt werden. Die Erkennung der Verriegelung wird durch die Erkennung der Information bestimmt.

Dies bietet den technischen Vorteil, dass das Erkennungsmerkmal zuverlässig eine Verriegelung des Spannelements, beispielsweise eines Bügels, anzeigt, so dass der Zustand des Spannelements sich mit einem scanbaren Element effizient erfassen lässt.

Gemäß einer beispielhaften Ausführungsform der Sicherungsvorrichtung ist das Verriegelungselement in der geschlossenen Spannelementstellung von der ersten Verriegelungsstellung in die zweite Verriegelungsstellung bewegbar und ist ausgebildet, in der zweiten Verriegelungsstellung das Spannelement in der geschlossenen Spannelementstellung zu verriegeln, und in der ersten Verriegelungsstellung das Spannelement für eine Bewegung in die offene Spannelementstellung zu entriegeln.

Dies bietet den technischen Vorteil, dass ein sicheres Verbinden des Steckergehäuses mit dem Gegen-Steckergehäuse über das Spannelement gewährleistet ist. Die Sicherungsvorrichtung erfüllt somit die Anforderungen, die an eine CPA-Verriegelung gestellt werden.

Gemäß einem zweiten Aspekt wird die oben beschriebene Aufgabe gelöst durch eine Steckverbindung mit einem Steckergehäuse und einem Gegen-Steckergehäuse, die über eine Sicherungsvorrichtung gemäß dem ersten Aspekt miteinander verbunden und gesichert sind.

Gemäß einem dritten Aspekt wird die oben beschriebene Aufgabe gelöst durch ein Sicherungssystem umfassend eine Sicherungsvorrichtung gemäß dem ersten Aspekt und ein Lesegerät, wobei das Lesegerät ausgebildet ist, das Erkennungsmerkmal zu erfassen, wenn sich das Klappelement in der zweiten Klappstellung befindet, um eine Verriegelung zu erkennen.

Gemäß einer beispielhaften Ausführungsform des Sicherungssystems ist das Lesegerät ausgebildet, das Erkennungsmerkmal nur dann zu erfassen, wenn sich das Klappelement in der zweiten Klappstellung und damit das Verriegelungselement in der zweiten Verriegelungsstellung befindet und nur in dieser Stellung eine korrekte Verriegelung zu erfassen.

### Kurze Figurenbeschreibung

Im Folgenden wird die Erfindung anhand von Ausführungsbeispielen und den Figuren näher beschrieben. Es zeigen:
- Fig. 1: eine schematische Darstellung der Zustände einer erfindungsgemäßen Sicherungsvorrichtung 100;
- Fig. 2a: eine 3D-Darstellung eines erfindungsgemäßen Klappelements 120 in der ersten Klappstellung 121, in der das Verdeckungsmerkmal 123 das Erkennungsmerkmal 124 verdeckt;
- Fig. 2b: eine 3D-Darstellung des Klappelements 120 aus Figur 2a in der zweiten Klappstellung 122, in der das Erkennungsmerkmal 124 sichtbar ist;
- Fig. 3a: eine 3D-Darstellung einer erfindungsgemäßen Klappvorrichtung 200 mit Klappelement 120 in der ersten Klappstellung 121, in der das Verdeckungsmerkmal 123 das Erkennungsmerkmal 124 verdeckt;
- Fig. 3b: eine 3D-Darstellung der Klappvorrichtung 200 aus Figur 3a in einer Zwischenstellung 126 zwischen der ersten und der zweiten Klappstellung, in der das Verdeckungsmerkmal 123 das Erkennungsmerkmal 124 verdeckt, wobei Koordinatensysteme K1, K2, K3 zur Definition der absoluten Lage dargestellt sind;
- Fig. 3c: eine 3D-Darstellung der Klappvorrichtung 200 aus Figur 3a in der zweiten Klappstellung 122, in der das Erkennungsmerkmal 124 sichtbar ist;
- Fig. 4a: eine 3D-Darstellung einer Sicherungsvorrichtung 100 umfassend ein Verriegelungselement 110, ein Klappelement 120 und ein Spannelement 300 in teilweise geöffneter Spannbügelstellung; und
- Fig. 4b: eine 3D-Darstellung einer Sicherungsvorrichtung 100 umfassend ein Verriegelungselement 110, ein Klappelement 120 und ein Spannelement 300 in geschlossener Spannbügelstellung.

Die Figuren sind lediglich schematische Darstellungen und dienen nur der Erläuterung der Erfindung. Gleiche oder gleichwirkende Elemente sind durchgängig mit den gleichen Bezugszeichen versehen.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

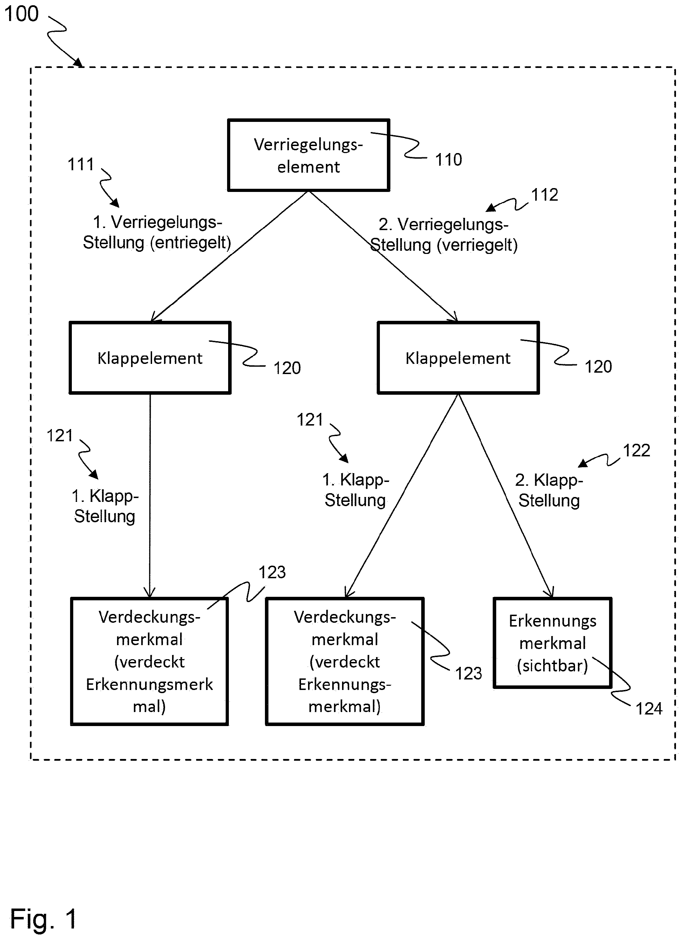

Fig. 1 zeigt eine schematische Darstellung der Zustände einer erfindungsgemäßen Sicherungsvorrichtung 100.

Die Sicherungsvorrichtung 100 dient zur Sicherung einer Verriegelung eines Verriegelungselements 110. Die Sicherungsvorrichtung 100 umfasst ein Verriegelungselement 110 und ein Klappelement 120.

Das Verriegelungselement 110 ist von einer ersten Verriegelungsstellung 111 in eine zweite Verriegelungsstellung 112 bewegbar und bewirkt in der zweiten Verriegelungsstellung 112 eine Verriegelung.

Das Klappelement 120 weist ein Erkennungsmerkmal 124 und ein Verdeckungsmerkmal 123 auf, die in absoluter Lage zueinander auf dem Klappelement (120) angeordnet sind. Das Klappelement 120 ist von einer ersten Klappstellung 121, in der das Verdeckungsmerkmal 123 das Erkennungsmerkmal 124 verdeckt, in eine zweite Klappstellung 122, in der das Erkennungsmerkmal 124 sichtbar ist, bewegbar, wenn sich das Verriegelungselement 110 in der zweiten Verriegelungsstellung 112 befindet.

Das Erkennungsmerkmal 124 zeigt dabei eine Information an. Diese Information kann beispielsweise eine Information über eine Verriegelung oder Nicht-Verriegelung durch das Verriegelungselement 110 umfassen. Es kann sich aber auch um jede andere Art von Information handeln.

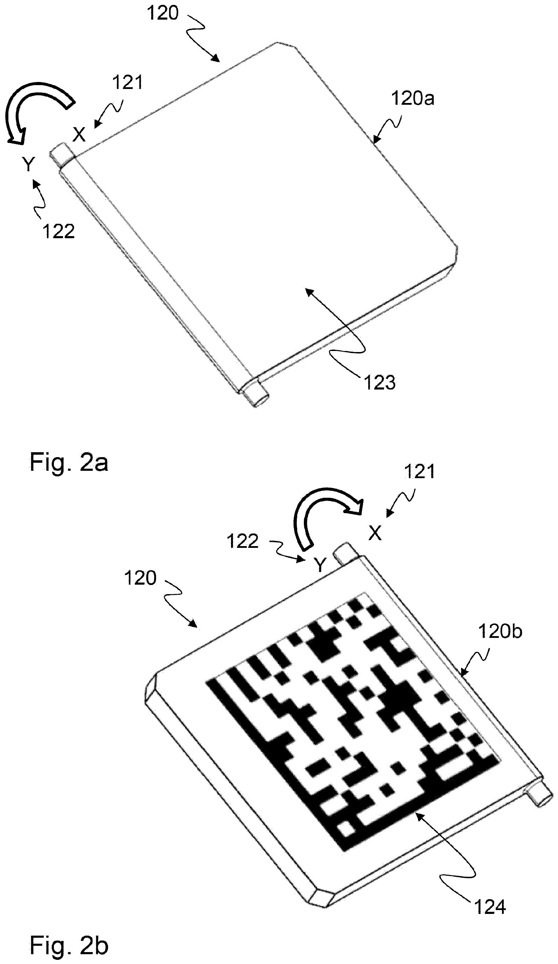

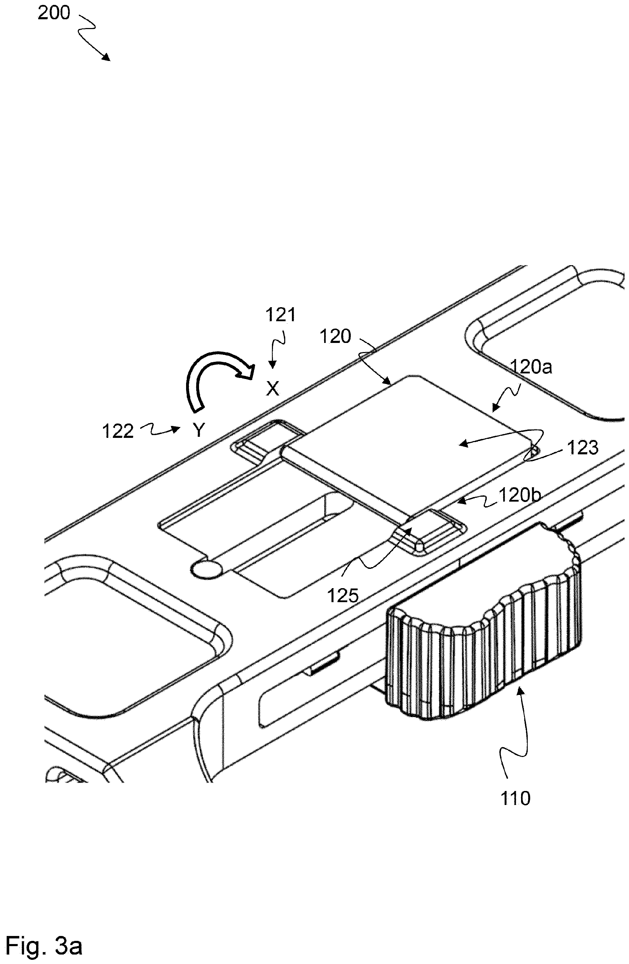

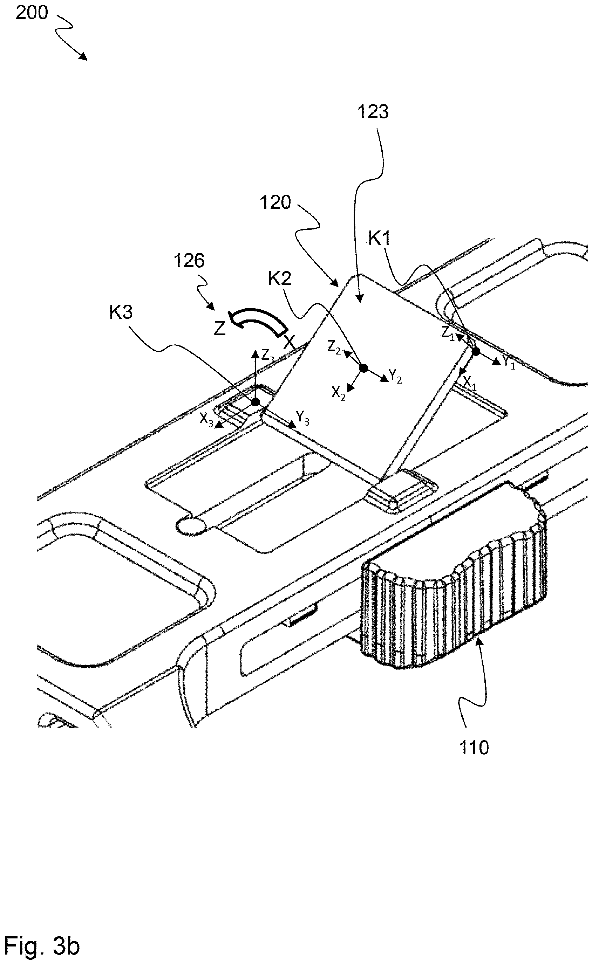

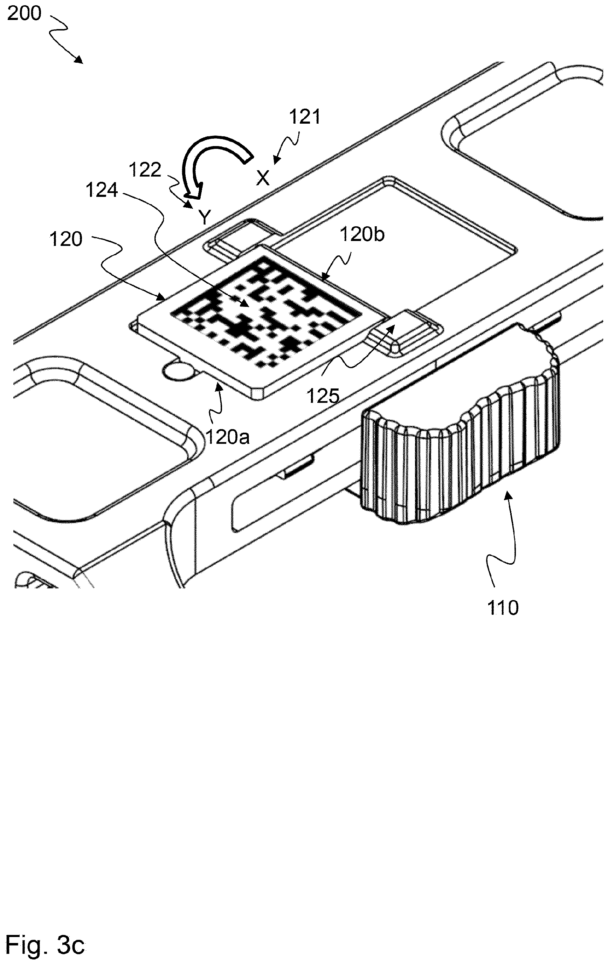

Ausführungsformen des Klappelements 120 mit Verdeckungsmerkmal 123 und Erkennungsmerkmal 124 sind näher zu den Figuren 2a, 2b, 3a, 3b und 3c beschrieben.

Die Figuren 2a und 2b zeigen eine 3D-Darstellung eines erfindungsgemäßen Klappelements 120. In Figur 2a befindet sich das Klappelement 120 in der ersten Klappstellung 121, in der das Verdeckungsmerkmal 123 das Erkennungsmerkmal 124 verdeckt. In Figur 2b befindet sich das Klappelement 120 in der zweiten Klappstellung 122, in der das Erkennungsmerkmal 124 sichtbar ist.

Wie gesagt, zeigen die Figuren 2a und 2b das Klappelement 120 mit dem Verdeckungs- 123 und Anzeigemerkmal 124. Das Verdeckungsmerkmal 123 ist hier als weiße Fläche dargestellt (Figur 2a); das Anzeigemerkmal 124 ist hier als Fläche mit einem sichtbaren Zeichen dargestellt, hier in Figur 2b am Beispiel eines QR Codes. Die weiße Fläche und die Fläche mit dem QR Code dienen nur zur Veranschaulichung. Ebenso können andere Zeichen als Verdeckungsmerkmal und Erkennungsmerkmal verwendet werden.

Das Klappelement 120 weist ein Erkennungsmerkmal 124 (siehe Figur 2b) und ein Verdeckungsmerkmal 123 (siehe Figur 2a) auf. Das Klappelement 120 ist von einer ersten Klappstellung 121, auch mit dem Buchstaben "X" bezeichnet, wie in Figur 2a dargestellt, in der das Verdeckungsmerkmal 123 das Erkennungsmerkmal 124 verdeckt, in eine zweite Klappstellung 122, auch mit dem Buchstaben "Y" bezeichnet, wie in Figur 2b dargestellt, in der das Erkennungsmerkmal 124 sichtbar ist, bewegbar. Das Klappelement ist so angeordnet, dass es nur dann in die zweite Klappstellung 122 bewegbar ist, wenn sich das Verriegelungselement 110 in der zweiten Verriegelungsstellung 112 befindet, und somit eine Verriegelung bewirkt. Das Erkennungsmerkmal 124 zeigt dann eine Verriegelung durch das Verriegelungselement 110 an.

Das Erkennungsmerkmal 124 und das Verdeckungsmerkmal 123 sind in absoluter Lage zueinander auf dem Klappelement 120 angeordnet, wie bereits weiter oben beschrieben. Dies heißt auch, dass das Verdeckungsmerkmal 123 und das Erkennungsmerkmal 124 in fester Lage auf dem Klappelement 120 angebracht sind, so dass sich die absoluten Lagen von Verdeckungsmerkmal 123 und Erkennungsmerkmal 124 auf dem Klappelement 120 zueinander sowie eine relative Lage des Verdeckungsmerkmals 123 in Bezug auf das Erkennungsmerkmal 124 bei einer Bewegung des Klappelements 120 nicht ändert.

Das Klappelement 120 weist eine erste Hauptseite 120a (in Figur 2a zu sehen) und eine der ersten Hauptseite 120a abgewandte zweite Hauptseite 120b (in Figur 2b zu sehen) auf.

Das Verdeckungsmerkmal 123 ist auf der ersten Hauptseite 120a des Klappelements 120 oder zumindest einem Teil der ersten Hauptseite 120a angebracht; und das Erkennungsmerkmal 124 ist auf der zweiten Hauptseite 120b des Klappelements 120 oder zumindest einem Teil der zweiten Hauptseite 120b angebracht. Es versteht sich, dass diese Anbringung auch umgekehrt sein kann.

Das Verdeckungsmerkmal 123 kann eine erste geometrische Struktur aufweisen, beispielsweise eine weiße Seite, wie in Figur 2a dargestellt. Wie in Figur 2b zu sehen, weist das Erkennungsmerkmal 124 eine zweite geometrische Struktur auf, die sich von der ersten geometrischen Struktur unterscheidet. Die zweite geometrischen Struktur ist hier beispielhaft als ein QR Code dargestellt, es kann sich aber auch um jede andere geometrische Struktur handeln, beispielsweise ein Zeichen, Piktogramm, QR-Code, Barcode, etc.

Wie gesagt, ist in diesem Beispiel der Figuren 2a und 2b ist die erste geometrische Struktur eine weiße Seite und die zweite geometrische Struktur ein QR Code. Es versteht sich, dass jede andere geometrischen Struktur bzw. Form verwendet werden kann. Beispielsweise kann die erste geometrische Struktur ein Dreieck sein und die zweite geometrische Struktur ein Quadrat sein oder es können andere geometrische Formen genutzt werden, die sich voneinander unterscheiden.

Das Erkennungsmerkmal 124 ist erkennbar, beispielsweise mit einem Lesegerät oder einem anderen Scanner lesbar und erkennbar, wenn es nicht durch das Verdeckungsmerkmal 123 verdeckt ist. D.h., wenn sich das Klappelement 120 in der zweiten Klappstellung 122 befindet, wie in Figur 2b dargestellt, ist das Erkennungsmerkmal 124 sichtbar und kann erkannt werden, beispielsweise durch das Lesegerät, beispielsweise einem scanbaren Element oder einem Photosensor, gelesen werden.

Wie in Figur 2b dargestellt, ist das Erkennungsmerkmal 124 mit einem Auge sichtbar, wenn es nicht durch das Verdeckungsmerkmal 123 verdeckt ist.

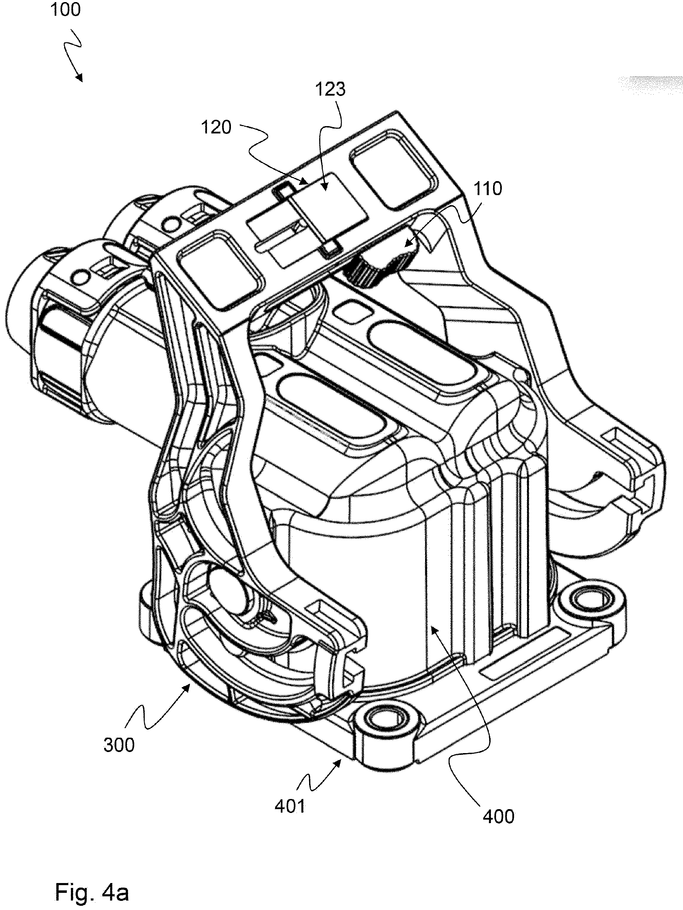

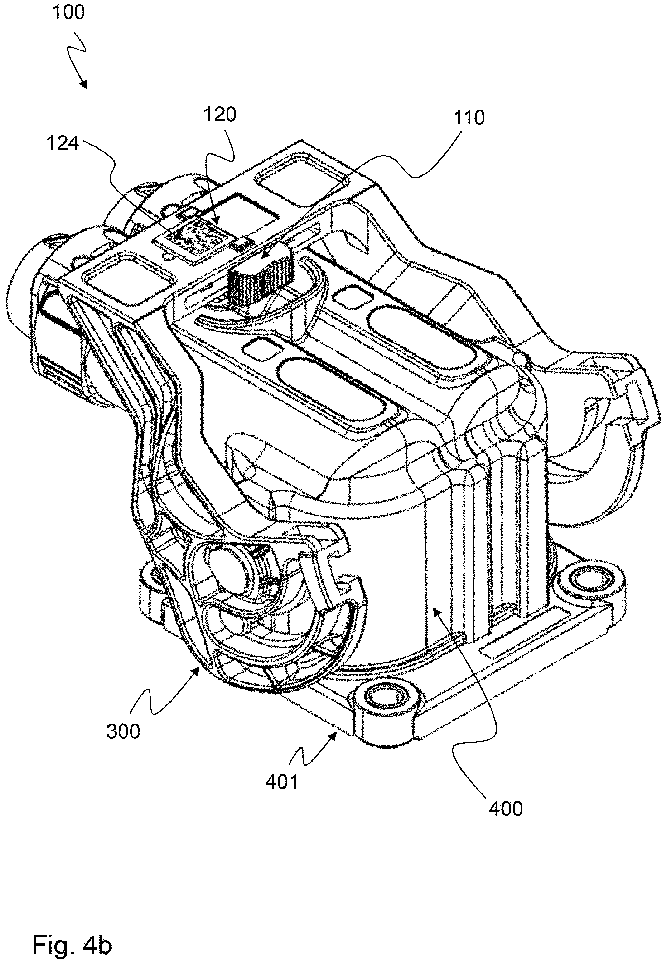

Die Figuren 3a, 3b und 3b zeigen eine 3D-Darstellung einer erfindungsgemäßen Klappvorrichtung 200 mit Klappelement 120, wie in den Figuren 2a und 2b dargestellt. In Figur 2a befindet sich das Klappelement 120 in der ersten Klappstellung 121, in der das Verdeckungsmerkmal 123 das Erkennungsmerkmal 124 verdeckt analog zu Figur 2a. In Figur 3c befindet sich das Klappelement 120 in der zweiten Klappstellung 122, in der das Erkennungsmerkmal 124 sichtbar ist analog zu Figur 2b. In Figur 3b befindet sich das Klappelement 120 in einer Zwischenstellung 126 (mit dem Buchstaben "Z" dargestellt) zwischen der ersten und der zweiten Klappstellung, in der das Verdeckungsmerkmal 123 das Erkennungsmerkmal 124 verdeckt. Die hier beschriebene Klappvorrichtung 200 kann in einer Sicherungsvorrichtung 100 eingesetzt werden, beispielsweise einer Sicherungsvorrichtung 100 wie in Figur 1 oder in den Figuren 4a und 4b beschrieben.

Insbesondere zeigen die Figuren 3a, 3b und 3c den Bewegungsablauf des Klappelements 120. In 0° Stellung (Figur 3a) wird die Fläche mit dem QR Code durch die weiße Fläche verdeckt. Das Element 120 verdeckt sich quasi selbst. Nachdem die CPA betätigt wurde (hier nur Klappmechanismus schematisch dargestellt), kann das Klappelement 120 gedreht werden und in der finalen 180° Stellung (Figur 3c) ist der QR Code sichtbar (= Erkennungsmerkmal 124).

Hierbei ist ersichtlich, dass sich in jeder Lage des Elements 120, auch in 30° (siehe Figur 3b) beide Merkmale 123, 124 immer in absoluter Position bzw. Lage zueinander befinden. Eine relative Bewegung zwischen beiden findet nicht statt.

Wie gesagt, weist das Klappelement 120 ein Erkennungsmerkmal 124 (siehe Figur 3c) und ein Verdeckungsmerkmal 123 (siehe Figuren 3a und 3b) auf. Das Klappelement 120 ist von einer ersten Klappstellung 121, wie in Figur 3a dargestellt, in der das Verdeckungsmerkmal 123 das Erkennungsmerkmal 124 verdeckt, über eine Zwischenstellung 126, wie in Figur 3b dargestellt, in eine zweite Klappstellung 122, wie in Figur 3c dargestellt, in der das Erkennungsmerkmal 124 sichtbar ist, bewegbar. Das Klappelement 120 ist so angeordnet, dass es nur dann in die zweite Klappstellung 122 bewegbar ist, wenn sich das Verriegelungselement 110 in der zweiten Verriegelungsstellung 112 befindet, und somit eine Verriegelung bewirkt. Das Erkennungsmerkmal 124 zeigt dann eine Information an, hier als Beispiel den QR Code. Die Information kann eine Verriegelung durch das Verriegelungselement 110 anzeigen, zum Beispiel beim Auslesen des QR Codes. Jede andere Information kann hier anstelle des QR Codes erfindungsgemäß genutzt werden.

Die Klappvorrichtung 200 umfasst ein Drehlager 125 zum Lagern des Klappelements 120. Das Drehlager 125 ist ausgebildet, eine Drehung des Klappelements 120 in die erste Klappstellung 121 und in die zweite Klappstellung 122 und in Zwischenstellungen 126 zwischen der ersten und der zweiten Klappstellung auszuführen.

Das Drehlager 125 ist auf einer Platte angeordnet, welche eine Begrenzung bzw. einen Anschlag für die Drehbewegung des Klappelements 120 von der ersten Klappstellung 121 in die zweite Klappstellung 122 bildet. Das Klappelement 120 ist ebenfalls als eine Platte ausgebildet, die an einer Seite ein Scharnier aufweist, das in das Drehlager 125 eingesetzt ist.

Das Verdeckungsmerkmal 123 und das Erkennungsmerkmal 124 sind in absoluter bzw. fester Lage auf dem Klappelement 120 angebracht, so dass sich eine relative Lage des Verdeckungsmerkmals 123 in Bezug auf das Erkennungsmerkmal 124 bei einer Bewegung des Klappelements 120 nicht ändert.

Dies ist anhand der Koordinatensysteme K1, K2 und K3 in Figur 3b illustriert. K1 bezeichnet das Koordinatensystem des Erkennungsmerkmals 124; K2 das Koordinatensystem des Verdeckungsmerkmals 123 und K3 das Koordinatensystem des Drehpunkts bzw. Drehlagers 125. Die beiden Koordinatensysteme K1 und K2 liegen absolut zueinander, denn sie sind auf den beiden Hauptseiten 120a, 120b des Klappelements 120 angeordnet. Die beiden Koordinatensysteme K1 und K2 sind relativ zu dem Koordinatensystem K3, denn K3 liegt auf dem Drehpunkt 125 bzw. Drehlager des Klappelements 120 und ändert sich nicht bei einer Drehung des Klappelements 120 im Gegensatz zu den Koordinatensystemen K1 und K2, die sich mit einer Drehung auf gleiche Weise bezüglich des Drehpunkts 125 ändern.

Wie bereits oben zu den Figuren 2a und 2b beschrieben, weist das Klappelement 120 eine erste Hauptseite 120a (in Figur 2a zu sehen) und eine der ersten Hauptseite 120a abgewandte zweite Hauptseite 120b (in Figur 2b zu sehen) auf.

Das Verdeckungsmerkmal 123 ist auf der ersten Hauptseite 120a des Klappelements 120 oder zumindest einem Teil der ersten Hauptseite 120a (hier in der Mitte der ersten Hauptseite 120a) angebracht; und das Erkennungsmerkmal 124 ist auf der zweiten Hauptseite 120b des Klappelements 120 oder zumindest einem Teil der zweiten Hauptseite 120b (hier in der Mitte der zweiten Hauptseite 120b) angebracht. Es versteht sich, dass diese Anbringung auch umgekehrt sein kann.

Die Ausführung des Klappelements 120 entspricht dem Klappelement 120 wie oben bereits zu den Figuren 2a und 2b beschrieben.

Die Sicherungsvorrichtung 100 ist ausgebildet, eine Steckerpositions-Sicherung (CPA) zur Sicherung einer Verriegelung eines Steckergehäuses 400 an einem Gegen-Steckergehäuse 401 vorzunehmen, beispielsweise gemäß dem Beispiel der Figuren 4a und 4b.

Mit der Sicherungsvorrichtung 100 und einem Lesegerät kann ein Sicherungssystem implementiert werden, das den Zustand des Verriegelungselements 110 sicher bestimmen und zur weiteren Verarbeitung beispielsweise an eine Steuerung übertragen kann. Ein solches Sicherungssystem umfasst eine Sicherungsvorrichtung 100 wie oben beschrieben und ein Lesegerät. Das Lesegerät ist dabei ausgebildet, das Erkennungsmerkmal 124 zu erfassen, wenn sich das Klappelement 120 in der zweiten Klappstellung 122 befindet, um eine Verriegelung zu erkennen.

Das Lesegerät kann beispielsweise ausgebildet sein, das Erkennungsmerkmal 124 nur dann zu erfassen, wenn sich das Klappelement 120 in der zweiten Klappstellung 122 und damit das Verriegelungselement 110 in der zweiten Verriegelungsstellung 112 befindet und nur in dieser Stellung eine korrekte Verriegelung zu erfassen.

Das Lesegerät kann die erfassten Informationen an eine Steuerung weitergeben, die dann einen Fehler anzeigen kann und entsprechende Schritte ausführen kann, um den Herstellungs- oder Konfektionierungsprozess zu steuern.

Die Figuren 4a und 4b zeigen 3D-Darstellungen einer Sicherungsvorrichtung 100 umfassend ein Verriegelungselement 110, ein Klappelement 120 und ein Spannelement 300. In Figur 4a ist das Spannelement 300 in geöffneter Spannbügelstellung, während es in Figur 4b in geschlossener Spannbügelstellung dargestellt ist. Die Sicherungsvorrichtung 100 umfasst eine Klappvorrichtung 200 wie oben zu den Figuren 3a bis 3c beschrieben und im Folgenden näher ausgeführt.

Die Sicherungsvorrichtung 100 ist ausgebildet, eine Steckerpositions-Sicherung (CPA) zur Sicherung einer Verriegelung eines Steckergehäuses 400 an einem Gegen-Steckergehäuse 401 vorzunehmen.

Die Sicherungsvorrichtung 100 umfasst neben den bereits oben beschriebenen Verriegelungselement 110 und Klappelement 120 auch ein Spannelement 300, beispielsweise einen Spannbügel, zum Einspannen des Steckergehäuses 400 in das Gegen-Steckergehäuse 401.

Das Spannelement 300 ist von einer offenen Spannelementstellung (siehe Figur 4a), in der das Steckergehäuse 400 in das Gegen-Steckergehäuse 401 einführbar ist, in eine geschlossene Spannelementstellung (siehe Figur 4b), in der das Steckergehäuse 400 elektrisch kontaktierend mit dem Gegen-Steckergehäuse 401 fixiert ist, bewegbar.

Das Verriegelungselement 110 ist an dem Spannelement 300 angebracht und ist ausgebildet, das Spannelement 300 zu verriegeln oder zu entriegeln.

Das Erkennungsmerkmal 124 zeigt eine Information an, beispielsweise eine Information über eine Verriegelung oder Nicht-Verriegelung des Spannelements 300 durch das Verriegelungselement 110. In Figur 4a wird kein Erkennungsmerkmal 124 sondern nur das Verdeckungsmerkmal 123 angezeigt, während in Figur 4b das Erkennungsmerkmal 124 angezeigt wird.

Das Verriegelungselement 110 ist in der geschlossenen Spannelementstellung von der ersten Verriegelungsstellung 111 in die zweite Verriegelungsstellung 112 bewegbar. Das Verriegelungselement 110 ist ausgebildet, in der zweiten Verriegelungsstellung 112 das Spannelement 300 in der geschlossenen Spannelementstellung zu verriegeln (siehe Figur 4b), und in der ersten Verriegelungsstellung 111 das Spannelement 300 für eine Bewegung in die offene Spannelementstellung zu entriegeln (siehe Figur 4a).

Bei einer Bewegung des Verriegelungselements 110 in die zweite Verriegelungsstellung 112 kann das Klappelement 120 von der ersten Klappstellung 121 in die zweite Klappstellung 122 umgeklappt werden, so dass das Erkennungsmerkmal 124 sichtbar und erkennbar ist. Es kann dann beispielsweise durch ein scanbares Element erfasst werden.

Befindet sich das Verriegelungselement 110 in der ersten Verriegelungsstellung 111, so ist das Klappelement 120 in der ersten Klappstellung 121 blockiert und kann nicht von der ersten Klappstellung 121 in die zweite Klappstellung 122 umgeklappt werden, so dass das Verdeckungsmerkmal 123 das Erkennungsmerkmal 124 verdeckt und somit das Erkennungsmerkmal 124 nicht erkennbar ist und beispielsweise durch ein scanbares Element nicht erfasst werden kann.

Die Figuren 4a und 4b zeigen somit auch eine Steckverbindung mit einem Steckergehäuse 400 und einem Gegen-Steckergehäuse 401, die über die Sicherungsvorrichtung 100 wie oben beschrieben miteinander verbunden und gesichert sind.

### BEZUGSZEICHENLISTE

- 100: Sicherungsvorrichtung
- 110: Verriegelungselement
- 111: erste Verriegelungsstellung (entriegelt)
- 112: zweite Verriegelungsstellung (verriegelt)
- 120: Klappelement
- 121: erste Klappstellung
- 122: zweite Klappstellung
- 123: Verdeckungsmerkmal
- 124: Erkennungsmerkmal
- 120a: erste Hauptseite des Klappelements
- 120b: zweite Hauptseite des Klappelements
- 200: Klappvorrichtung
- 125: Drehlager der Klappvorrichtung
- 126: Zwischenstellung zwischen erster und zweiter Klappstellung
- 300: Spannelement bzw. Spannbügel
- 400: Steckergehäuse
- 401: Gegen-Steckergehäuse

## Patentansprüche

1. Sicherungsvorrichtung (100) zur Sicherung einer Verriegelung eines Verriegelungselements (110), wobei die Sicherungsvorrichtung (100) Folgendes umfasst:
ein Verriegelungselement (110), das von einer ersten Verriegelungsstellung (111) in eine zweite Verriegelungsstellung (112) bewegbar ist, wobei das Verriegelungselement (110) in der zweiten Verriegelungsstellung (112) eine Verriegelung bewirkt; und
ein Klappelement (120) mit einem Erkennungsmerkmal (124) und einem Verdeckungsmerkmal (123), die in absoluter Lage zueinander auf dem Klappelement (120) angeordnet sind, wobei das Klappelement (120) von einer ersten Klappstellung (121), in der das Verdeckungsmerkmal (123) das Erkennungsmerkmal (124) verdeckt, in eine zweite Klappstellung (122), in der das Erkennungsmerkmal (124) sichtbar ist, bewegbar ist, wenn sich das Verriegelungselement (110) in der zweiten Verriegelungsstellung (112) befindet,
wobei das Erkennungsmerkmal (124) eine Information anzeigt.

2. Sicherungsvorrichtung (100) nach Anspruch 1,
wobei das Verdeckungsmerkmal (123) und das Erkennungsmerkmal (124) in fester Lage auf dem Klappelement (120) angebracht sind, so dass sich eine relative Lage des Verdeckungsmerkmals (123) in Bezug auf das Erkennungsmerkmal (124) bei einer Bewegung des Klappelements (120) nicht ändert.

3. Sicherungsvorrichtung (100) nach Anspruch 1 oder 2,
wobei das Klappelement (120) eine erste Hauptseite (120a) und eine der ersten Hauptseite (120a) abgewandte zweite Hauptseite (120b) aufweist,
wobei das Verdeckungsmerkmal (123) auf der ersten Hauptseite (120a) des Klappelements (120) oder zumindest einem Teil der ersten Hauptseite (120a) angebracht ist; und
wobei das Erkennungsmerkmal (124) auf der zweiten Hauptseite (120b) des Klappelements (120) oder zumindest einem Teil der zweiten Hauptseite (120b) angebracht ist.

4. Sicherungsvorrichtung (100) nach einem der vorstehenden Ansprüche,
wobei das Verdeckungsmerkmal (123) eine erste geometrische Struktur aufweist; und
wobei das Erkennungsmerkmal (124) eine zweite geometrische Struktur aufweist, die sich von der ersten geometrischen Struktur unterscheidet.

5. Sicherungsvorrichtung (100) nach einem der vorstehenden Ansprüche,
wobei das Erkennungsmerkmal (124) erkennbar ist, wenn es nicht durch das Verdeckungsmerkmal (123) verdeckt ist.

6. Sicherungsvorrichtung (100) nach einem der vorstehenden Ansprüche,
wobei das Erkennungsmerkmal (124) mit einem Auge sichtbar ist, wenn es nicht durch das Verdeckungsmerkmal (123) verdeckt ist.

7. Sicherungsvorrichtung (100) nach einem der vorstehenden Ansprüche, umfassend:
Ein Drehlager (125) zum Lagern des Klappelements (120), wobei das Drehlager (125) ausgebildet ist, eine Drehung des Klappelement (120) in die erste Klappstellung (121) und in die zweite Klappstellung (122) auszuführen.

8. Sicherungsvorrichtung (100) nach einem der vorstehenden Ansprüche,
wobei die Sicherungsvorrichtung (100) ausgebildet ist, eine Steckerpositions-Sicherung (CPA) zur Sicherung einer Verriegelung eines Steckergehäuses (400) an einem Gegen-Steckergehäuse (401) vorzunehmen.

9. Sicherungsvorrichtung (100) nach einem der vorstehenden Ansprüche, ferner umfassend:
ein Spannelement (300) zum Einspannen eines Steckergehäuses (400) in ein Gegen-Steckergehäuse (401), wobei das Spannelement (300) von einer offenen Spannelementstellung, in der das Steckergehäuse (400) in das Gegen-Steckergehäuse (401) einführbar ist, in eine geschlossene Spannelementstellung, in der das Steckergehäuse (400) elektrisch kontaktierend mit dem Gegen-Steckergehäuse (401) fixiert ist, bewegbar ist; und
wobei das Verriegelungselement (110) an dem Spannelement (300) angebracht ist und ausgebildet ist, das Spannelement (300) zu verriegeln oder zu entriegeln.

10. Sicherungsvorrichtung (100) nach Anspruch 9,
wobei das Verriegelungselement (110) in der geschlossenen Spannelementstellung von der ersten Verriegelungsstellung (111) in die zweite Verriegelungsstellung (112) bewegbar ist und ausgebildet ist, in der zweiten Verriegelungsstellung (112) das Spannelement (300) in der geschlossenen Spannelementstellung zu verriegeln, und in der ersten Verriegelungsstellung (111) das Spannelement (300) für eine Bewegung in die offene Spannelementstellung zu entriegeln.
